# EUROPEAN PATENT APPLICATION

(11) **EP 1 164 589 A1**
(43) Date of publication of application: **19.12.2001**
(21) Application number: 01114137.1
(22) Date of filing: 11.06.2001
(51) Int. Cl.: G11B 20/18, G11C 29/00, G06F 11/10

(54) **Storage device having an error correction function**

(30) Priority: 12.06.2000 JP 2000175688
(71) Applicant: NEC CORPORATION, Tokyo (JP)
(72) Inventor: Mio, Yuichiro, Minato-ku, Tokyo (JP)
(74) Representative: Glawe, Delfs, Moll & Partner

(57) **Abstract**

A storage device includes a one-bit inverter (15), used in a test mode operation, for inverting a specified one of data bits including write data and ECC data. The data bits of the write data section and the ECC data section, after being subjected to the one-bit inversion, are stored in a memory cell array (11) and an ECC cell array (12), respectively. The write data section subjected to correction by an ECC correction unit (17) using the ECC data section is compared against the original write data. The test result is judged based on the comparison and the error correction signal, which indicates whether or not the error correction is successfully performed

## Description

### BACKGROUND OF THE INVENTION

### (a) Field of the Invention

The present invention relates to a storage device having an error correction function and, more particularly, to a storage device capable of performing a read test at a speed equivalent to the speed of a normal read operation employed by a user.

### (b) Description of the Related Art

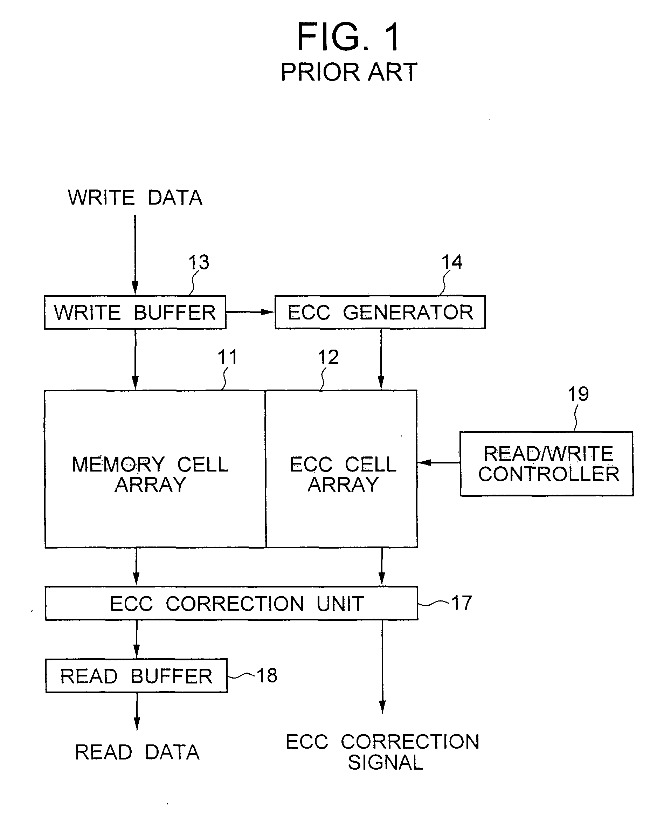

Fig. 1 is a block diagram illustrating the general configuration of a conventional storage device having an error correction function using an error-correcting code (ECC). The conventional storage device includes a memory cell array 11 for storing write data therein, an ECC cell array 12 for storing ECC data therein, a write buffer 13 for temporarily storing the write data supplied from outside the storage device, a read/write controller 19 for reading/writing data from/into the memory cell array 11 and the ECC cell array 12, an ECC generator 14 for generating ECC data based on the write data, an ECC correction unit 17 for correcting the read data read from the memory cell array 11 based on the ECC data read from the ECC cell array 12, and a read buffer 18 for delivering read data corrected by the ECC correction unit 17.

In a write operation, write data is temporarily stored in the write buffer 13, and then stored in the memory cells in the memory cell array 11. The write data is also supplied to the ECC generator 14, which generates ECC data and stores the same in the memory cells in the ECC cell array 12.

In a read operation, the data stored in the memory cell array 11 and the ECC data stored in the ECC cell array 12 are supplied to the ECC correction unit 17, which performs error correction in accordance with those data. The resultant read data, after the ECC correction, is supplied through the read buffer 18 to outside the storage device. The ECC correction unit 17 outputs an ECC correction signal indicative of whether or not an error correction is successfully performed.

In a test operation for the aforementioned conventional storage device, the read test is generally performed in a test mode without using the ECC correction function. In this regard, the read test cannot be performed using a signal path same as the signal path used in the normal operation mode using the ECC correction function, so long as the read data is correct. Thus, the read test cannot assure the read operation at the normal operational speed of the storage device. In addition, if an error of a single bit occurs in the read test due to a defect resulting from the higher test speed, the error will be corrected by means of the ECC correction function, thereby allowing the storage device to pass the read test irrespective of the presence of the defect therein. Thus, a reliable test cannot be conducted in the conventional storage device.

### SUMMARY OF THE INVENTION

In view of the aforementioned problems in the conventional storage device having an ECC correction function, it is an object of the present invention to provide a storage device having an ECC correction function, which can be tested accurately in a test mode at the speed equivalent to the normal operational speed.

The present invention provides a storage device including an input section for receiving write data having a plurality of bits, an error-correcting code (ECC) generator for generating ECC data having a plurality of bits based on the write data, a one-bit inverter for inverting a specified one of bits of the write data and the ECC data in a test operation to output a set of data bits including a write data section and an ECC data section, a memory cell array for storing the data bits of the write data section, an (ECC) cell array for storing the data bits of the ECC data section, a read/write controller for reading/writing the data bits of the write data section and the ECC data section from/to the memory cell array and the ECC cell array, respectively, and an ECC correction unit for correcting the data bits of the write data section read from the memory cell array based on the data bits of the ECC data section read from the ECC cell array to output a corrected data bits of the write data section and an ECC correction signal, the ECC correction signal indicating whether or not an ECC correction is successfully performed.

The present invention also provides a method for testing a storage device including the steps of: generating a error-correcting code (ECC) data based on a write data; inverting a specified one of bits of the write data and the ECC data to output a set of data bits including a write data section and an ECC data section; writing the data bits of the write data section and the ECC data section into a memory cell array and an ECC cell array, respectively; correcting the data bits of the write data section read from the memory cell array based on the data bits of the ECC data section read from the ECC cell array to output a corrected data bits of the write data section and an ECC correction signal, the ECC correction signal indicating whether or not an ECC correction is successfully performed; comparing original data of the write data against the write data section after being subjected to correcting of the data bits; and judging pass or fail based on results of the comparison and the ECC correction signal.

In accordance with the storage device and the method for testing a storage device of the present invention, the storage device can be tested in a test mode at a speed equivalent to the normal operational speed, while using the ECC correction function irrespective of the presence or absence of a defective bit in the data read from the storage device.

The above and other objects, features and advantages of the present invention will be more apparent from the following description, referring to the accompanying drawings.

### BRIEF DESCRIPTION OF THE DRAWINGS

Fig. 1 is a block diagram illustrating the configuration of a conventional storage device.
Fig. 2 is a block diagram illustrating the configuration of a storage device according to an embodiment of the present invention.
Fig. 3 is a circuit diagram illustrating a specific example of a one-bit inverter in the storage device of Fig. 2.

### DETAILED DESCRIPTION OF THE PREFERRED EMBODIMENT

Now, the present invention will be described below in more detail with reference to the accompanying drawings in accordance with a preferred embodiment of the present invention. It is to be noted that similar reference numerals designate similar constituent elements throughout the drawings.

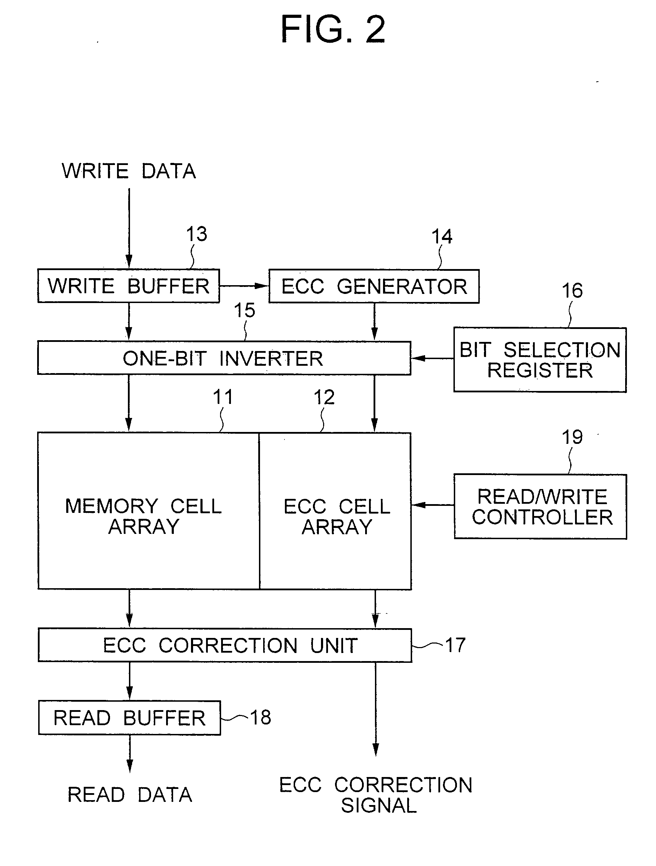

Referring to Fig. 2, a storage device according to the preferred embodiment of the present invention includes a memory cell array 11 for storing write data therein, an ECC cell array 12 for storing ECC data therein, a write buffer 13 for writing data supplied from outside the storage device in the memory cell array 11, an ECC generator 14 for generating ECC data based on the write data, a read/write controller 19 for writing/reading data into/from the memory cell array 11 and the ECC cell array 12, a one-bit inverter 15 for inverting one of the bits of the write data and the ECC data before writing the data to deliver a set of data bits including a write data section and an ECC data section, an ECC correction unit 17 for correcting the read data read from the memory cell array 11 based on the ECC data read from the ECC cell array 12, a read buffer 18 for delivering read data corrected by the ECC correction unit 17, and a bit selection register 16 for specifying the single bit to be inverted by the one-bit inverter 15 among the set of bits including the write data and the ECC data.

In the example to follow, the write data includes eight bits and the ECC data includes four bits, the latter being generated based on the multiplications in the matrix of the eight-bit write data.

The one-bit inverter 15 is used for conducting a read test using the ECC correction function upon completion of the product. The one-bit inverter 15 inverts any one of the bits of the write data supplied from outside the storage device and the ECC data generated by the ECC generator 14, thereby generating an error in the set of data bits stored in the memory cell array 11 and the ECC cell array 12. This ensures that the ECC correction function is performed at any time in the read test. A bit selection register 16 is used for specifying the bit to be inverted by the one-bit inverter 15.

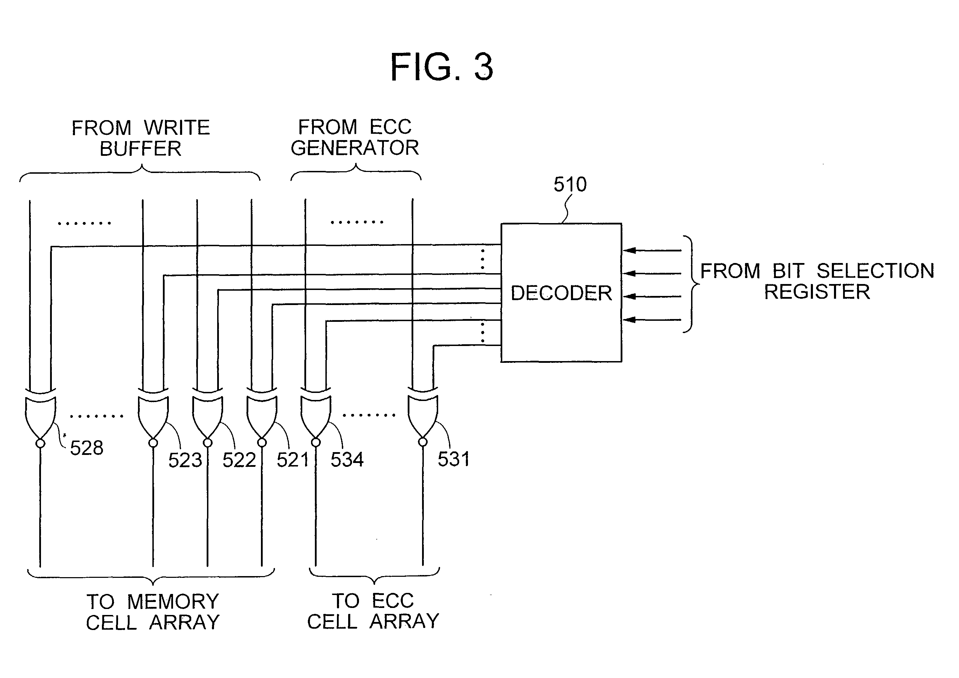

Referring to Fig. 3, there is shown a specific example of the one-bit inverter 15 shown in Fig. 2. The one-bit inverter 15 includes a decoder 510 for decoding the data supplied from the bit selection register 16, exclusive-OR gates (Ex-OR gates) 521 to 528 each disposed for a corresponding bit of the output from the write buffer 13, and Ex-OR gates 531 to 534 each disposed for a corresponding bits of the output from the ECC generator 14. In this embodiment, the one-bit inverter 15 includes twelve Ex-OR gates in total, corresponding to the write buffer 13 having eight bits and the ECC generator 14 having four bits.

The decoder 510, having four bits for the input data and twelve bits for the output data, decodes four-bit input data supplied from the bit selection register 16 to deliver twelve-bit output data to the Ex-OR gates 521 to 528 and the Ex-OR gates 531 to 534. The four-bit input data specifies the sequential number or order of the bit of the data to be inverted, as counted from the least significant bit toward the most significant bit. The twelve-bit output data includes "0s" for the non-selected bits and "1" for the selected bit to be inverted.

The data from the decoder 510 and the data from the write buffer 13 are Ex-ORed in the Ex-OR gates 521 to 528, and the resultant data is supplied to the memory cell array 11. On the other hand, the data from the decoder 510 and the data from the ECC generator 14 are Ex-ORed in the Ex-OR gates 531 to 534, and the resultant data is supplied to the ECC cell array 12.

In a test operation of the storage device of Fig. 2, the write buffer 13 receives a specified write data, and the bit to be inverted is set in the bit selection register 16. For example, setting eight-bit write data "00010001", for example, in the write buffer 13 may cause the ECC generator 14 to generate a four-bit ECC data such as "0110". In this example, setting of "7" in the bit selection register 16 causes the seventh bit, as counted from the least significant bit toward the most significant bit, to be inverted.

In the above example, the decoder 510 with four bits for input and twelve bits for output decodes the "7" input from the bit selection register 16 to output data "000001000000". The eight significant bits of this data are supplied to the Ex-OR gates 521 to 528 corresponding to the output of the write buffer 13, whereas the four less significant bits are supplied to the Ex-OR gates 531 to 534 corresponding to the output of the ECC generator 14. The seventh bit "1" is supplied to an Ex-OR gate 523 from the decoder 510.

In the Ex-OR gates 521 to 528, the significant eight-bit data "00000100" from the decoder 510 and the eight-bit data "00010001" from the write buffer 13 are Ex-ORed. On the other hand, in the Ex-OR gates 531 to 534, the less significant four-bit data "0000" from the decoder 510 and the ECC data "0110" from the ECC generator 14 are Ex-ORed. Consequently, the one-bit inverter 15 outputs data "000101010110", the significant eight-bit data "00010101" being written to the memory cell array 11 and the less significant four-bit data "0110" being written to the ECC cell array 12. Thus, a single bit among the set of bits including the write data from the write buffer 13 and the ECC data from the ECC generator 14 is inverted to generate a one-bit error in the whole data bits. The data bits are written to the memory cell 11 and the ECC cell array 12, with the one-bit error being present in the data bits.

Now, to read the data stored in the test operation, the data in the memory cell 11 and the ECC cell array 12 is read at a predetermined read speed which is equivalent to the read speed at the normal operational mode. In this case, the data bits of the write data section "00010101" with a one-bit error are read from the memory cell 11 and the data bits of the ECC data section "0110" are read from the ECC cell array 12, and these data bits are supplied to the ECC correction unit 17. The ECC correction unit 17 performs error correction in accordance with these data bits and outputs an ECC correction signal "1" indicative of a safe error correction being performed, thereby allowing the resultant corrected data "00010001" to be supplied to the read buffer 18.

If the read data stored in the read buffer 18 is correct and the ECC error signal is "1", then it is judged that the data of 12 bits in total is correctly read from the memory cell array 11 and the ECC cell array 12 to pass the storage device through the memory test.

It is assumed here that there is a defective memory cell in the memory cell array 11 or in the ECC cell array 12 among the memory cells to be accessed in the read test, the defective memory cell providing a wrong bit in the read data due to the higher speed of the read operation, for example. In this case, it is also assumed that the defective bit is not the one of bits of the data that is inverted by the one-bit inverter 15, and for example, the output data from the ECC cell array 12 assumes "0100" instead of the correct ECC data "0110". In this case, since the number of the wrong bits in the read data is two, the ECC correction function does not successfully correct the read data, and thus the incorrect data is supplied to the read buffer 18, with the ECC correction signal being set at "1" to indicate an successful error correction. The wrong data is detected by the memory tester which compares the read data in the read buffer 18 against the original write data stored in the memory tester, thereby indicating a "fail" in the memory test.

On the other hand, if the defective bit is the same as the one inverted by the one-bit inverter 15, then the output data from the memory cell array 11 assumes "00010001" instead of the bit-inverted data "00010101". In this case, the correct data is supplied to the read buffer 18, and this fact is detected by the memory tester. However, the ECC correction signal output from the ECC correction unit 17 assumes "0", which indicates that the error correction is not successfully performed. This reveals that the inverted bit is not correctly read, indicating a "fail" in the memory test.

As described above, since the present embodiment allows the ECC correction unit 17 to operate for correction of the wrong bit at any time in the test mode due to provision of the one-bit error, the test operation can be conducted using the normal signal path that is used in the normal operation mode. This allows an accurate test for the storage device. In addition, the test operation detects the "fail" of the storage device while operating the ECC correction function, even in the case of a single wrong bit being stored in or read from the memory cell. It is to be noted here that, in the conventional memory device, the read data may be corrected in the test mode by the ECC correction function of the storage device if a single wrong bit occurs in the read data, whereby the storage device passes the defective memory device through the read test irrespective of the presence of the wrong bit.

In the above example, "7" is set in the bit selection register 16 and thus the seventh bit from the least significant bit is inverted among the whole bits including the write data and the ECC data. However, any bit can be inverted among the whole data bits. In addition, in the embodiment described above, the one-bit inverter 15 includes a decoder 510 and Ex-OR gates in number corresponding to the number of bits read from the cell arrays. Other various configurations can be also employed however. The one-bit inverter 15 and the bit selection register 16 are used only for the test mode and not used in the normal operation mode after the product is delivered to the user. In this case, the data stored in the bit selection register is set at "0" at any time.

Since the above embodiments are described only for examples, the present invention is not limited to the above embodiments and various modifications or alterations can be easily made therefrom by those skilled in the art without departing from the scope of the present invention.

## Claims

1. A storage device comprising an input section (13) for receiving write data having a plurality of bits, an error-correcting code (ECC) generator (14) for generating ECC data having a plurality of bits based on said write data, a memory cell array (11) for storing said write data, an ECC cell array (12) for storing said ECC data, a read/write controller (19) for reading/writing said write data and said ECC data from/to said memory cell array (11) and said ECC cell array (12), respectively, and an ECC correction unit (17) for correcting said write data read from said memory cell array (11) based on said ECC data read from said ECC cell array (12) to output a corrected write data and an ECC correction signal, said ECC correction signal indicating whether or not an ECC correction is successfully performed, **characterized by**:
a one-bit inverter (15) for inverting a specified one of bits of said write data and said ECC data in a test operation before writing said write data and said ECC data into said memory cell array (11) and said ECC cell array (12).

2. The storage device as defined in claim 1, wherein said one-bit inverter (15) passes said one of said bits without an inversion thereof in a normal operation mode.

3. The storage device as defined in claim 1, further comprising a bit selection register (16) for storing data specifying said one of said data bits.

4. The storage device as defined in claim 3, wherein said one-bit inverter (15) includes a decoder (510) for decoding an output from said bit selection register (16) to output data having bits in number corresponding to a number of bits of said set of data bits, and a plurality of exclusive ORs (521 to 528, and 531 to 534) each disposed for a corresponding one of said bits of said set of data bits.

5. A method for testing a storage device comprising the steps of:
generating an error-correcting code (ECC) data based on a write data;
inverting a specified one of bits of said write data and said ECC data to output a set of data bits including a write data section and an ECC data section;
writing said data bits of said write data section and said ECC data section into a memory cell array and an ECC cell array, respectively;
correcting said data bits of said write data section read from said memory cell array based on said data bits of said ECC data section read from said ECC cell array to output a corrected data bits of said write data section and an ECC correction signal, said ECC correction signal indicating whether or not an ECC correction is successfully performed;
comparing original data of said write data against said write data section after being subjected to correcting of said data bits; and
judging pass or fail based on results of said comparison and said ECC correction signal.
